# EUROPEAN PATENT SPECIFICATION

(11) **EP 3 313 959 B1**
(45) Date of publication and mention of the grant of the patent: **08.01.2020**
(21) Application number: 16727092.5
(22) Date of filing: 24.05.2016
(51) Int. Cl.: C09K 11/59

(54) **PHOSPHOR COMPOSITIONS AND LIGHTING APPARATUS THEREOF**
LEUCHTSTOFFZUSAMMENSETZUNGEN UND BELEUCHTUNGSVORRICHTUNG DAFÜR
COMPOSITIONS DE LUMINOPHORE ET APPAREIL D'ÉCLAIRAGE ASSOCIÉ

(30) Priority: 23.06.2015 US 201514747174
(43) Date of publication of application: 02.05.2018
(73) Proprietor: Current Lighting Solutions, LLC, East Cleveland, OH 44112 (US)
(72) Inventor: CAMARDELLO, Samuel, Joseph, Niskayuna, NY 12309 (US); SRIVASTAVA, Alok, Mani, Niskayuna, NY 12309 (US); DU, Fangming, Niskayuna, NY 12309 (US); COMANZO, Holly, Ann, Niskayuna, NY 12309 (US); BEERS, William, Winder, Niskayuna, NY 12309 (US); COHEN, William, Erwin, Niskayuna, NY 12309 (US)
(74) Representative: FRKelly
(86) International application number: PCT/US2016/033890
(87) International publication number: WO 2016/209468

(56) References cited:
- KR-B1- 101 434 459
- US-A1- 2014 264 418
- ZHIGUO XIA ET AL: "Crystal growth of CaSiOBr: New photoluminescence bromosilicate host", JOURNAL OF CRYSTAL GROWTH, vol. 318, no. 1, 27 October 2010 (2010-10-27), pages 958-961, XP028164515, ISSN: 0022-0248, DOI: 10.1016/J.JCRYSGRO.2010.10.058 [retrieved on 2010-10-27]

## Description

### BACKGROUND

The invention relates generally to phosphor compositions applicable to lighting systems. The invention also relates to lighting apparatus employing these phosphors and blends thereof.

Generation of "white light" is currently achieved by so called "white light emitting diodes (white LEDs)" that are constituted by employing a near-ultraviolet (UV) or blue emitting LED in conjunction with a phosphor or a blend of phosphors. Red-emitting phosphors based on complex fluoride materials activated by Mn⁴⁺, such as those described in US 7,358,542, US 7,497,973, and US 7,648,649, absorb blue light strongly, and efficiently emit between about 610 nanometers and 635 nanometers with little deep red/NIR emission. Thus, the luminous efficacy and the quantum efficiency of white LEDs maximizes under blue excitation (440 nanometers-460 nanometers) as compared to other available red phosphors.

These complex fluorides can be utilized in combination with yellow-green emitting phosphors such as cerium-doped yttrium aluminum garnet Y₃Al₅O₁₂:Ce³⁺ (YAG) or other garnet compositions to achieve warm white light (CCTs<5000 K on the blackbody locus, color rendering index (CRI) >80) from a blue LED, equivalent to that produced by current fluorescent, incandescent and halogen lamps. YAG has been mostly used in these white LED systems because of its broad emission spectrum that peaks in the yellow spectral region, and the high quantum efficiency of the LED system under blue light excitation. The drawback of YAG based LED systems is the relatively poor color rendering properties and high color temperature (CCT). For example, when an object is illuminated under such currently used white LEDs, they cannot imitate the colors illuminated by natural light. KR101434459B1 discloses a novel bromosilicate-based phosphor for near-ultraviolet excitation, a method of preparing the same, and a light-emitting device using the same. ZHIGUO XIA ET AL, in "Crystal growth of Ca3SiO4Br2: New photoluminescence bromosilicate host", JOURNAL OF CRYSTAL GROWTH, vol. 318, no.1 discloses single crystals of new bromosilicate compound Ca₃SiO₄Br₂ which were grown out of high-temperature Ca₂SiO₄/CaBr₂ melts by the slow cooling process.

Therefore, there is a need for phosphor compositions and blends that efficiently absorb blue radiation, provide high quantum efficiency, and result in improved color rendering in white light emitting lighting devices.

### Summary

Accordingly, the present disclosure relates to a phosphor composition as detailed in claim 1. The present disclosure also relates to a light apparatus as detailed in claim 12. Advantageous embodiments are detailed in the dependent claims.

### BRIEF DESCRIPTION

Briefly, most of the embodiments of the present invention provide a phosphor composition including a first phosphor that includes a phase of general formula (I),

L₃ZO₄(Br₂₋ₙXₙ): Eu²⁺ (I)

where 0 ≤ n ≤ 1; L is Zn, Mg, Ca, Sr, Ba, or combinations thereof; Z is Si, Ge, or a combination thereof; and X is F, Cl, I, or combinations thereof. Some embodiments relate to a lighting apparatus that includes a light source and the phosphor composition radiationally coupled to the light source.

In some embodiments, a phosphor composition includes a first phosphor having a phase of general formula: L₃ZO₄Br₂:Eu²⁺, a phase of general formula: L₉Z₃O₁₂Br₆:Eu²⁺, a phase of general formula: L₅Z₂O₇Br₄:Eu²⁺, or combinations of two or more of these phases, where L is Zn, Mg, Ca, Sr, Ba, or combinations thereof; and Z is Si, Ge, or a combination thereof.

Some embodiments provide a phosphor composition that includes a first phosphor including a phase of general formula: L₃ZO₄Br₂:Eu²⁺, where L is Zn, Mg, Ca, Sr, Ba, or combinations thereof; and Z is Si, Ge, or a combination thereof; and a second phosphor including K₂SiF₆:Mn⁴⁺. A ratio of a spectral weight of the phase of general formula L₃ZO₄Br₂:Eu²⁺ to a spectral weight of the second phosphor is in a range from about 1:5 to about 5:1.

### DRAWINGS

These and other features, aspects, and advantages of the present invention will become better understood when the following detailed description is read with reference to the accompanying drawings, in which like characters represent like parts throughout the drawings, wherein:
FIG. 1 shows excitation and emission spectra of a phase of a first phosphor, in accordance with one embodiment of the invention;
FIG. 2 shows excitation and emission spectra of an additional phase of the first phosphor, in accordance with one embodiment of the invention;
FIG. 3 shows excitation and emission spectra of an additional phase of the first phosphor, in accordance with another embodiment of the invention;
FIG. 4 is a schematic cross sectional view of a lighting apparatus, in accordance with one embodiment of the invention; and
FIG. 5 is a schematic cross sectional view of a lighting apparatus, in accordance with another embodiment of the invention.

### DETAILED DESCRIPTION

In the following specification and the claims, the singular forms "a", "an" and "the" include plural preferences unless the context clearly dictates otherwise. As used herein, the term "or" is not meant to be exclusive and refers to at least one of the referenced components being present and includes instances in which a combination of the referenced components may be present, unless the context clearly dictates otherwise.

Approximating language, as used herein throughout the specification and claims, may be applied to modify any quantitative representation that could permissibly vary without resulting in a change in the basic function to which it is related. Accordingly, a value modified by a term or terms, such as "about," is not limited to the precise value specified. In some instances, the approximating language may correspond to the precision of an instrument for measuring the value.

Unless defined otherwise, technical and scientific terms used herein have the same meaning as is commonly understood by one of skill in the art to which this invention belongs. The terms "comprising," "including," and "having" are intended to be inclusive, and mean that there may be additional elements other than the listed elements. The terms "first", "second", and the like, as used herein do not denote any order, quantity, or importance, but rather are used to distinguish one element from another. In the following specification and the claims that follow, the singular forms "a", "an" and "the" include plural references unless the context clearly dictates otherwise.

As used herein, the terms "phosphor", "phosphor material" or "phosphor composition" may be used to denote both a single phosphor as well as blends of two or more phosphors. As used herein, the term "phase" refers to a material or a portion of material (for example, phosphor) having a crystal structure or stoichiometry uniform throughout the material or the portion of the material, and distinct from other materials or portions. In some embodiments, the phase of the material has substantially uniform properties throughout the material or the portion of material, which are often distinct from other phases. As used herein, the terms "lamp", "lighting apparatus" or "lighting system" refer to any source of visible and ultraviolet light, which can be generated by at least one light emitting element producing a light emission when energized, for example, a phosphor or a light emitting diode.

The terms "substitution" and "doping" refer to addition of an element or atom in a material. The added element or atom may partially or completely replace another element or atom in the material. It should be noted that phosphors described herein may be denoted by a formula, for example, L₃ZO₄Br₂:Eu²⁺. As understood by those skilled in the art, this type of notation means that the phosphor includes the composition L₃₋ₐEuₐSiO₄Br₂, where 'Eu' has been doped into the composition in an amount 'a' that can vary from 0.0 to 0.5. The element 'Eu' is referred to as a 'dopant' or an 'activator.' The terms "activator" or "activator ion", as used herein, refers to an ion (for example Eu²⁺) doped in a phosphor composition that forms luminescent center and is responsible for the luminescence of the phosphor.

Each of the general formulae listed herein is independent of every other general formula listed. Specifically, x, y, z, a, n and other variables that may be used as numeric placeholders in a formula are not related to any usage of x, y, z, a, n and other variables that may be found in other formulas or compositions.

The phosphor compositions and blends are described herein, in conjunction with techniques and apparatus converting LED-generated ultraviolet (UV), violet, or blue radiation into a desired color light or white light, for general illumination or other purposes. It should be appreciated, however, that the invention is also applicable to the conversion of radiation from ultra violet (UV), violet, or blue lasers, as well as other light sources, to white light.

Some embodiments of the present invention are directed to a phosphor composition including a first phosphor having a phase of general formula (I): L₃ZO₄(Br₂₋ₙXₙ): Eu²⁺, where L is Zn, Mg, Ca, Sr, Ba, or combinations thereof; Z is Si, Ge or a combination thereof; X is F, Cl, I or combinations thereof; and 0≤ n ≤1. In some embodiments, the first phosphor includes a phase of general formula L₃ZO₄Br₂:Eu²⁺. The phase of general formula (I) may further include manganese, tin, chromium, bismuth, lead, antimony, lanthanide elements, or combinations thereof. In particular embodiments, L is Sr, and Z is Si. In these embodiments, the first phosphor includes a phase of formula Sr₃SiO₄Br₂: Eu²⁺. The phase of formula Sr₃SiO₄Br₂: Eu²⁺ has a monoclinic crystal structure.

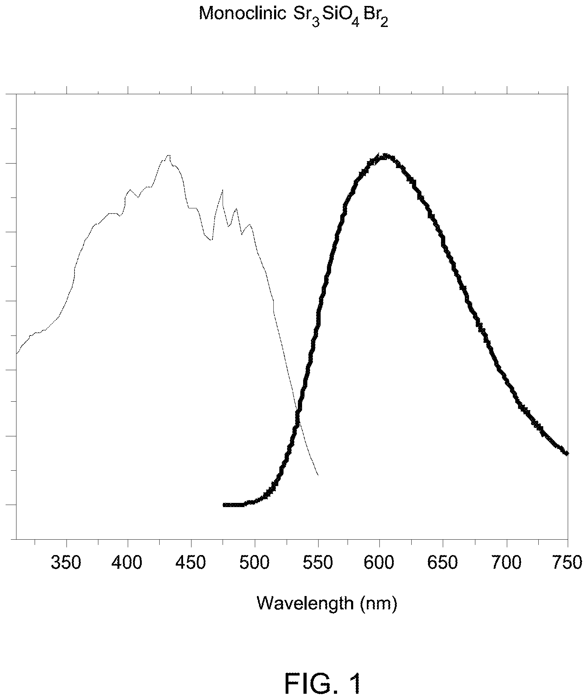

FIG. 1 shows the excitation-emission spectra of the phosphor phase of formula Sr₃SiO₄Br₂: Eu²⁺ upon UV excitation. The monoclinic phase of formula Sr₃SiO₄Br₂: Eu²⁺ is a red-emitting phosphor, which generates a broad emission band centered at 615 nanometers upon ultra violet (UV) excitation, as shown in FIG. 1. This monoclinic phase of formula Sr₃SiO₄Br₂: Eu²⁺ is chemically stable and provides a low color temperature (CCT). This red-emitting phosphor Sr₃SiO₄Br₂: Eu²⁺ may be deployed alone, or may be mixed with one or more other phosphor, for example, a yellow-green emitting phosphor for generating white light.

The first phosphor further includes an additional phase of general formula (II): L₉Z₃O₁₂(Br₆₋ₙXₙ):Eu²⁺, general formula (III): L₅Z₂O₇(Br₄₋ₙXₙ):Eu²⁺, or a combination thereof; wherein 0 ≤ n ≤ 1; L is Zn, Mg, Ca, Sr, Ba, or combinations thereof; Z is Si, Ge or a combination thereof; and X is F, Cl, I or combinations thereof. The additional phase may further include manganese, tin, chromium, bismuth, lead, antimony, lanthanide elements, or combinations thereof. In one embodiment, the first phosphor consists essentially of the phase of formula (I).

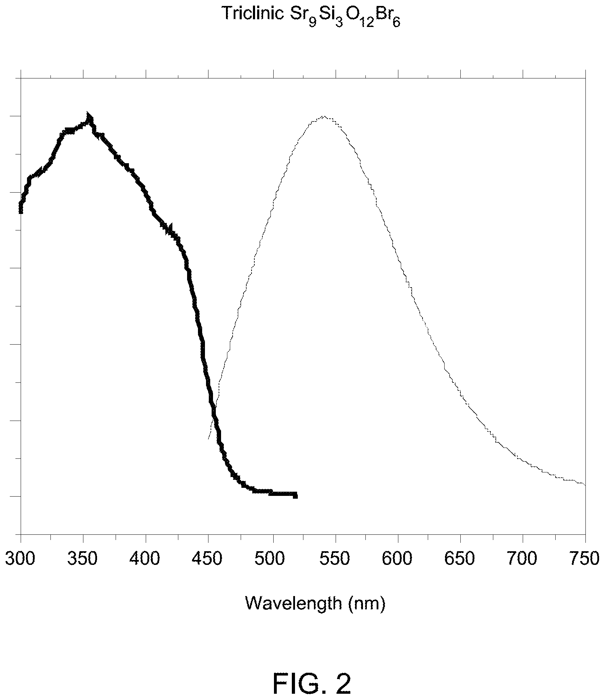

In some embodiments, the first phosphor includes the additional phase having a formula Sr₉Si₃O₁₂Br₆: Eu²⁺. This phase of formula Sr₉Si₃O₁₂Br₆: Eu²⁺ is chemically stable, and has a triclinic crystal structure. FIG. 2 shows the excitation-emission spectrum of the phosphor phase of formula Sr₉Si₃O₁₂Br₆: Eu²⁺ upon UV excitation. This phase is a green-emitting phosphor that generates a broad emission band centered at 550 nanometers upon UV excitation, as shown in FIG. 2.

In some embodiments, the first phosphor includes the additional phase having a general formula L₅Si₂O₇Br₄: Eu²⁺. L is as described above. This additional phase of general formula L₅Si₂O₇Br₄: Eu²⁺ may produce a color-tunable emission spectrum, which may be useful for down-converting the blue radiation of the LED devices to, for example, green or orange-red radiation. That is, the Eu²⁺ emission wavelength of the phosphor of general formula L₅Si₂O₇Br₄: Eu²⁺ may be tuned from green to red emission. For example, the emission color may be tuned from green to red by substituting Ca²⁺ or Ba²⁺ for Sr²⁺, due to the change in crystal fields. The crystal fields may be changed both by cationic and anionic substitutions.

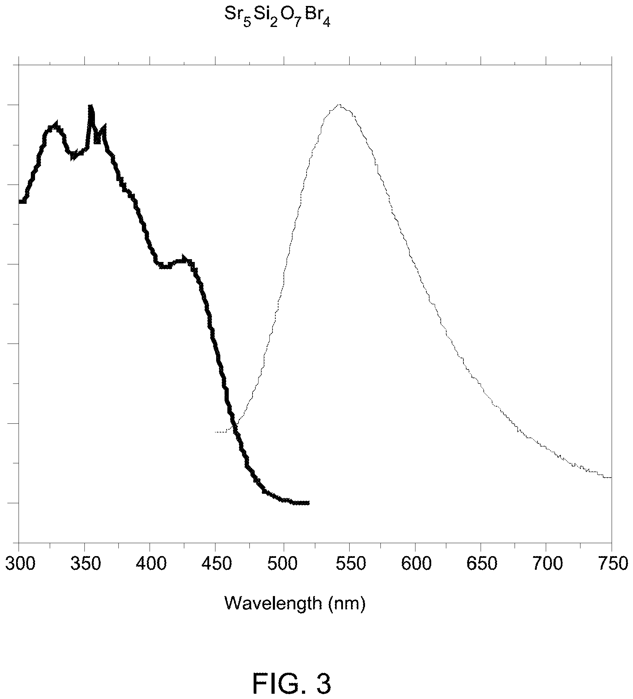

In some embodiments, the emission band of the additional phase of general formula L₅Si₂O₇Br₄: Eu²⁺ exists in a wavelength range from about 590 nanometers to about 620 nanometers. In some other embodiments, the emission band of this addition phase exists in a wavelength range from about 515 nanometers to about 580 nanometers. For example, the excitation-emission spectrum of the phosphor phase of formula Sr₅Si₂O₇Br₄: Eu²⁺ upon UV excitation, is illustrated in FIG. 3. The phosphor phase Sr₅Si₂O₇Br₄: Eu²⁺ shows a peak emission near 550 nanometers.

These additional phosphor phases may be synthesized individually depending on the processing conditions. These green-emitting phosphors of formula Sr₉Si₃O₁₂Br₆: Eu²⁺ and Sr₅Si₂O₇Br₄: Eu²⁺ may be used alone or in combination with one or more other phosphors, for example, yellow- and/or red-emitting phosphors for generating a white light. These phosphors may be utilized in conjunction with, for example, a highly efficient GaN-based near-UV or blue-emitting LED, and form a color gamut.

The emission spectra of the additional phosphor phases, for example, Sr₉Si₃O₁₂Br₆: Eu²⁺ and Sr₅Si₂O₇Br₄: Eu²⁺ are depressed in the yellow region and shifted towards the blue region as compared to the conventional garnet phosphors (for example, yttrium aluminum garnet-YAG). The emission of each of these phosphors is such that each of these may replace the standard YAG phosphor that is generally applied in blue LED devices.

These green-emitting phosphor phases in combination with a red emitting phosphor (for example, a phosphor of general formula IV described later) produce white light with improved color rendering properties as compared to that often achieved using conventional garnet phosphors, when employed in the LED-based lighting systems/devices. A deficiency in the yellow region of these phosphors leads to increased red-green color contrast (or enhanced red-green separation) when objects are viewed under these LED lighting systems/devices in comparison to white LEDs that employ conventional yellow-green garnets. In some embodiments, an improvement in red-green contrast of a blend employing the green-emitting phosphor phases is at least about 5 percent, based on the red-green contrast of a blend including conventional garnet. In some specific embodiments, the improvement in red-green contrast is at least about 10 percent. Additionally, the blue-shifted green emission of these phosphor phases provides additional advantage to a color blind human when used for green light emitting devices, for example in traffic lights and backlights.

In some embodiments, the Si⁴⁺ (Z site) of the host lattice of one or more phases of the first phosphor is partially or completely replaced by Ge⁴⁺ or any other cation with valence of 4⁺. This may allow for tuning the spectrum obtained from the first phosphor. In one embodiment, the Si⁴⁺ of the host lattice is completely replaced by Ge⁴⁺, wherein the emission from the host lattice changes. However, the quantum efficacy still remains the same as that for Si⁴⁺. In addition, Br may be partially or fully substituted with an additional halogen, such as F, Cl, I, or combinations thereof.

Each phase of the first phosphor having general formula (I), (II) and (III) may be doped with an additional activator ion. That is, the activator ion "Eu²⁺" may be partially substituted with one or more additional activator ions. Examples of the additional activator ions include Mn²⁺, Mn⁴⁺, Ce³⁺, Sn²⁺, Bi³⁺, Sb³⁺, Cr³⁺, Pb²⁺, or combinations thereof, which may be substituted on the L site.

In some embodiments, a phosphor composition is provided that includes a first phosphor including a phase of general formula: L₃ZO₄Br₂:Eu²⁺, a phase of general formula: L₉Z₃O₁₂Br₆:Eu²⁺, a phase of general formula: L₅Z₂O₇Br₄:Eu²⁺, or a combination of two or more of these phases. In these embodiments, L is Zn, Mg, Ca, Sr, Ba, or combinations thereof; and Z is Si, Ge or a combination thereof. In some embodiments, the phosphor composition includes a phase of formula Sr₃SiO₄Br₂:Eu²⁺ and a phase of formula Sr₉Si₃O₁₂Br₆:Eu²⁺. In some embodiments, the phosphor composition includes a phase of formula Sr₃SiO₄Br₂:Eu²⁺ and a phase of formula Sr₅Si₂O₇Br₄:Eu²⁺. In some embodiments, the phosphor composition includes a phase of formula Sr₃SiO₄Br₂:Eu²⁺, a phase of formula Sr₉Si₃O₁₂Br₆:Eu²⁺ and a phase of formula Sr₅Si₂O₇Br₄:Eu²⁺. In some embodiments, the first phosphor consists essentially of Sr₃SiO₄Br₂:Eu²⁺.

The phosphors of general formulae L₃ZO₄Br₂:Eu²⁺, L₉Z₃O₁₂Br₆:Eu²⁺ and L₅Z₂O₇Br₄:Eu²⁺ as described herein, absorb radiation in near-UV or blue region (a wavelength range between about 350nm and about 470nm), and emit red or green light. These phosphors may be used in a lighting apparatus to generate light suitable for general illumination and other purposes. In some embodiments, these phosphors may be used in a lighting apparatus to generate a red light or a green light for applications such as toys, traffic light, backlight, etc. In some embodiments, these phosphors may be utilized to produce white light.

Typically, red, green, and yellow emitting inorganic phosphors are utilized in conjunction with a near-UV or blue-emitting LED, for example a GaN based LED, to achieve a complete color gamut that properly renders colored objects and provides a desirable color temperature. In some embodiments, the red-emitting phosphor for example, Sr₃SiO₄Br₂: Eu²⁺ is combined with green-emitting phosphors to produce a "warm" white light. The red-emitting phosphor Sr₃SiO₄Br₂:Eu²⁺ and its blends in conjunction with UV and/or blue LED chips display high quantum efficiency, which may produce white-light LEDs having a high CRI at any given color temperature (CCT).

In some embodiments, the phosphor composition further includes a second phosphor that emits red light. In one embodiment, the second phosphor is a Mn⁴⁺ doped phosphor of general formula IV: A₂ [MF₆]:Mn⁴⁺, where A is Li, Na, K, Rb, Cs, or combinations thereof; and M is Si, Ge, Sn, Ti, Zr, Al, Ga, In, Sc, Hf, Y, La, Nb, Ta, Bi, Gd, or combinations thereof.

The Mn⁴⁺ doped phosphor of formula IV is a Mn⁴⁺ doped complex fluoride that is a line emitter and generates red light. As used herein, the term "complex fluoride" refers to a coordination compound containing at least one coordination center, surrounded by fluoride ions acting as ligands, and charge-compensated by counter ions as necessary. For example, in the Mn⁴⁺ doped complex fluoride of formula K₂SiF₆:Mn⁴⁺, the coordination center is Si and the counter ion is K. Complex fluorides are occasionally written down as a combination of simple, binary fluorides but such a representation does not indicate the coordination number for the ligands around the coordination center. The square brackets (occasionally omitted for simplicity) indicate that the complex ion they encompass is a new chemical species, different from the simple fluoride ion. The activator ion (Mn⁴⁺) also acts as a coordination center, substituting part of the centers of the host lattice, for example, Si. The host lattice (including the counter ions) may further modify the excitation and emission properties of the activator ion.

In particular embodiments, the coordination center of the complex fluoride phosphors, that is, M in formula IV, is Si, Ge, Sn, Ti, Zr, or combinations thereof. More particularly, the coordination center is Si, Ge, Ti, or combinations thereof; the counter ion, that is, A in general formula IV, is Na, K, Rb, Cs, or combinations thereof. Examples of the complex fluoride phosphors of formula IV include K₂[SiF₆]:Mn⁴⁺, K₂[TiF₆]:Mn⁴⁺, K₂[SnF₆]:Mn⁴⁺, Cs₂[TiF₆]:Mn⁴⁺, Rb₂[TiF₆]:Mn⁴⁺, Cs₂[SiF₆]:Mn⁴⁺, Rb₂[SiF₆]:Mn⁴⁺, Na₂[TiF₆]:Mn⁴⁺, Na₂[ZrF₆]:Mn⁴⁺, or combinations thereof. In particular embodiments, the second phosphor is K₂SiF6:Mn⁴⁺ (manganese doped potassium fluorosilicate; PFS).

In some embodiments, the phosphor composition includes a first phosphor including a phase of general formula I and a second phosphor of formula general IV. In particular embodiments, the phosphor composition includes a phosphor Sr₃SiO₄Br₂: Eu²⁺ and a complex fluoride phosphor K₂SiF₆:Mn⁴⁺. Both the phosphors emit red light, and thus contribute to substantially same emission spectrum. Use of the phosphor Sr₃SiO₄Br₂: Eu²⁺ in combination with K₂SiF6:Mn⁴⁺ in the phosphor composition may advantageously reduce the amount of K₂SiF6:Mn⁴⁺ required in the final composition while maintaining or improving the color rendering properties when compared to a phosphor composition that includes only K₂SiF6:Mn⁴⁺ for red emission. In these instances, the phosphor Sr₃SiO₄Br₂ partially replaces the complex fluoride K₂SiF6:Mn⁴⁺ in the composition.

The amounts (spectral weights) of both the red emitting phosphors in the phosphor composition can be optimized to achieve the desired spectral and color rendering properties at a desired color temperature. In one embodiment, a ratio of the spectral weights of the phosphor of general formula (I) to the Mn⁴⁺ doped phosphor of general formula (IV) ranges from about 1:9 to about 9:1. In a particular embodiment, the spectral weight ratio of the phosphor Sr₃SiO₄Br₂: Eu²⁺ to the complex fluoride phosphor K₂SiF6:Mn⁴⁺ is in a range from about 1:5 to about 5:1. "Spectral weight" is a relative amount that each phosphor in a composition contributes to the overall emission spectrum of the device. The spectral weights of all the individual phosphors and any residual bleed from the LED source should add up to 100%.

In some embodiments, the phosphor composition may further include a third phosphor to form a phosphor blend that produces white light from a lighting apparatus. For example, the phosphor blend may find application in a white light emitting LED-based device. In one embodiment, the third phosphor is a green emitting phosphor having a peak emission in a wavelength range from about 520 nanometers to about 580 nanometers. Suitable examples of the third phosphor include, but are not limited to, green emitting garnets (for example YAG), orthosilicates, beta-sialon, oxyhalides and combinations thereof. In particular embodiment, the third phosphor is Ca₁₋ₓEuₓMg(SiO₄)₄Cl₂ (CASI-Eu).

Some embodiments of the present disclosure advantageously provide a red emitting phosphor Sr₃SiO₄Br₂: Eu²⁺ and its combination with K₂SiF6:Mn⁴⁺ in a phosphor composition. In some embodiments, the phosphor Sr₃SiO₄Br₂ is combined with the green-emitting phosphor to produce white light emitting phosphor composition. In some embodiments, a combination of Sr₃SiO₄Br₂: Eu²⁺ and K₂SiF6:Mn⁴⁺ is blended with the green-emitting phosphor. These phosphor compositions provide a high red-green contrast. Suitable examples of the green-emitting phosphors include CASI-Eu and YAG. Table 3 shows spectral characterization results for such compositions that are described in detailed in the example section below.

The phosphors listed above are not intended to be limiting. Any other phosphors, commercial and non-commercial, that form non-reactive blends with the phosphors disclosed herein may be used in the blends, and are considered within the scope of the present disclosure. Furthermore, some additional phosphors may be used, e.g., those emitting throughout the visible spectrum region, at wavelengths substantially different from those of the phosphors described herein. These additional phosphors may be used in the blend to customize the white color of the resulting light, and to produce light sources with improved light quality.

The phosphors, as described in the above embodiments, may be produced by mixing powders of the constituent compounds and then firing the mixture under a reducing atmosphere or by any technique known in the art.

For white-light LEDs, the combination of the light from the phosphor composition and the LED chip provides a color point with corresponding color coordinates i.e., ccx and ccy on the CIE (International Commission on Illumination) chromaticity diagram, and a correlated color temperature (CCT) (may also be referred to as 'color temperature'); and its spectral distribution provides a color rendering capability (or color rendering properties), measured by the color rendering index (CRI). The color rendering index (CRI) is used to evaluate the ability to render each of 15 colors (R₁- R₁₅ values) against a standard value of 100. The general color rendering index, Rₐ, is the average of the values for R₁ to R₈. A special color rendering index, R₉, represents red content. As known to those skilled in the art, the relative proportions (spectral weights) of each phosphor in the phosphor composition may be adjusted, so that when their emissions are blended and employed in a lighting device or apparatus, there is produced visible light of desired light output, for example predetermined CCT and predetermined ccx and ccy values. As stated, a white light is preferably produced.

Some embodiments of the invention are directed to a lighting apparatus that includes a phosphor composition radiationally coupled to a light source. The phosphor composition includes the first phosphor or its blends as disclosed in the above embodiments. In one embodiment, the light source can be a semiconductor radiation source, for example a light emitting diode (LED) or an organic light emitting device (OLED). Radiationally coupled means that radiation from the light source is transmitted to the phosphor composition, and the phosphor composition emits radiation of a different wavelength. A combination of the light from the light source and the light emitted from the phosphor composition may be used to produce a desired color emission or white light. For example, a white light emitting LED device may be based on a blue emitting InGaN LED chip. The blue emitting LED chip may be coated with a phosphor composition to convert some of the blue radiation to a complementary color, e.g. a red emission, a green emission or a white emission.

Non-limiting examples of lighting apparatus or devices include devices for excitation by light-emitting diodes (LEDs) such as fluorescent lamps, cathode ray tubes, plasma display devices, liquid crystal displays (LCD's), UV excitation devices, such as in chromatic lamps, lamps for backlighting, liquid crystal systems, plasma screens, xenon excitation lamps, and UV excitation marking systems. The list of these devices is meant to be merely exemplary and not exhaustive.

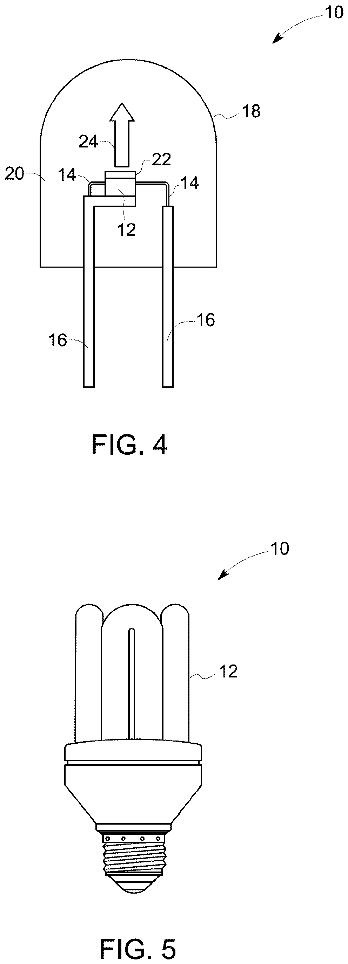

FIG. 4 illustrates a lighting apparatus or lamp 10 according to some embodiments of the present invention. The lamp 10 includes a light emitting diode (LED) chip 12, and leads 14 electrically attached to the LED chip. The leads 14 provide current to LED chip 12 and thus cause it to emit radiation. The LED chip 12 may be any semiconductor blue or ultraviolet light source, for example based on a nitride compound semiconductor of formula InᵢGaⱼAlₖN (where 0≤i; 0≤j; 0≤k and i + j + k =1) having an emission wavelength greater than about 250 nm and less than about 550 nm. More particularly, the chip 12 may be a near-UV or blue emitting LED having a peak emission wavelength from about 300 nm to about 500 nm. Such LEDs are known in the art. In the lighting apparatus 10, a phosphor composition (as described in the above embodiments) is disposed on a surface of the LED chip 12, and is radiationally coupled to the chip 12. The phosphor composition can be deposited on the LED 12 by any appropriate method known in the art. The light emitted by the LED chip 12 mixes with the light emitted by the phosphor composition to produce desired emission (indicated by arrow 24).

Although the general discussion of the exemplary structures of the invention discussed herein are directed toward inorganic LED based light sources, it should be understood that the LED chip may be replaced by an organic light emissive structure or other radiation source, unless otherwise noted, and that any reference to an LED chip or semiconductor is merely representative of any appropriate radiation source.

With continued reference to FIG. 4, the LED chip 12 may be encapsulated within an envelope 18, which encloses the LED chip and an encapsulant material 20. The envelope 18 may be, for example, glass or plastic. The LED chip 12 may be enclosed by the encapsulant material 20. The encapsulant material 20 may be a low temperature glass, a thermoplastic or thermoset polymer, or a suitable resin known in the art, for example, a silicone or epoxy resin. In an alternate embodiment, the lamp 10 may only include an encapsulant without an outer envelope 18.

Various structures of the lamp 10 are known in the art. For example, in some embodiments, the phosphor composition may be interspersed within the encapsulant material, instead of being disposed directly on the LED chip 12. In some other embodiments, the phosphor composition may be coated onto a surface of the envelope, instead of being formed over the LED chip. Moreover, in some embodiments, the lamp may include a plurality of LED chips. These various structures discussed with respect to FIG. 4 may be combined, with the phosphor composition located in any two or all three locations or in any other suitable location, such as separately from the envelop or integrated into the LED. Further, different phosphor compositions may be used in different parts of the structure.

In any of the above structures, the LED based lighting apparatus 10 may also include a plurality of particles (not shown) to scatter or diffuse the emitted light. These scattering particles would generally be embedded in the encapsulant 20. The scattering particles may include, for example, particles made from Al₂O₃ (alumina) or TiO₂ (titania). The scattering particles may effectively scatter the light emitted from the LED chip 12, preferably with a negligible amount of absorption.

In some embodiments, the lighting apparatus can be a fluorescent lamp or a compact fluorescent lamp (CFL), in combination with a LED. For instance, a combination of a LED-generated light and a phosphor-generated light may be used to produce visible light having enhanced color contrast. In this instance, a LED can be mounted in the base of the fluorescent lamp, for example a CFL lamp. The LED can add or supplement light in select wavelength regions of the visible spectrum (such as, a portion of blue region) to the light being generated by the phosphor composition coated on a glass envelope 11 of a lamp 10 (FIG. 5).

By use of the embodiments described in the present disclosure, particularly the phosphor compositions described herein, lamps can be provided producing white light having high red-green contrast, high luminosity, and high CRI values for a low range of color temperatures of interest (2500 K to 4000 K) for general illumination.

### EXAMPLES

The examples that follow are merely illustrative, and should not be construed to be any sort of limitation on the scope of the claimed invention.

The following series of examples present the synthesis of reference phosphors in accordance with some embodiments of the present invention. A comparative analysis of the characterization studies of the phosphors prepared using these synthesis methods is also presented.

### Example 1: Synthesis of phosphor materials

Materials: High purity strontium carbonate (SrCO₃), silicon oxide (SiO₂), europium oxide (Eu₂O₃) (99.9%) and high purity ammonium bromide (NH₄Br) (98%) were used without further purification. All the raw materials were sieved through 325 mesh.

The starting materials, the weight of the reactants (in grams), and the firing temperature to make a 5 gram batch of phosphor are listed below in Table 1. In each case, 1% Eu²⁺ was doped on the Sr²⁺ site under the condition of 0.5% H₂ - 99.5% N₂ atmosphere. The weight of SiO₂ was adjusted for the amount of water absorbed to the powder. To form compounds of Sr₃SiO₄Br₂ and Sr₉Si₃O₁₂Br₆, the same amount of starting materials were used; the final firing temperature was different based on its transition from monoclinic to triclinic crystal form. For Sr₉Si₃O₁₂Br₆, 50% excess weight of NH₄Br was added before the 2^{nd} firing.

**Table 1: Reactants and conditions for synthesis of phosphor materials**

| **Phase** | SrCO₃ (grams) | Eu₂O₃ (grams) | SiO₂ (grams) | NH₄Br (grams) | 1^{st} fire temperature | 2^{nd} fire temperature |
|---|---|---|---|---|---|---|
| Sr₃SiO₄Br₂ | 4.2431 | 0.0511 | 0.6129 | 1.8958 | 700°C | 750°C |
| Sr₉Si₃O₁₂Br₆ | 4.2431 | 0.0511 | 0.6129 | 1.8958 | 600°C | 650°C |
| Sr₅Si₂O₇Br₄ | 3.9327 | 0.0473 | 0.6817 | 2.1085 | 800°C | 950°C |

The starting materials (SrCO₃, SiO₂, and Eu₂O₃) for synthesizing the phosphor compositions were weighed into a plastic bottle, and then blended with yttria stabilized zirconia (YSG) media in the presence of excess NH₄Br and ball milled for 1 hour. Then, the blended powder was placed in an alumina crucible and fired at the "1^{st} fire" temperature as noted in Table 1 for 1 hour under 0.5% H₂ - 99.5% N₂ atmosphere. After firing, the powder was filtered through a 60 mesh sieve and re-blended for 1 hr., and the powder was re-fired at the "2^{nd} fire" temperature (Table 1) under 0.5% H₂ - 99.5% N₂ atmosphere. The product phosphors were collected and characterized by X-ray diffraction.

For synthesizing Sr₃SiO₄Br₂, Sr₉Si₃O₁₂Br₆ and Sr₅Si₂O₇Br₄ phases, the starting materials (SrCO₃ or SrBr₂), hold times (5hrs to 10hrs), atmosphere (0.5% H₂ or 1% H₂) or temperature may be varied to synthesize one or more of the desired phosphor phase.

### Example 2 Characterization of phosphor materials

The product phosphors, as synthesized in example 1, were sieved through 325 mesh and were then characterized by X-ray diffraction. Powder X-ray diffraction patterns were obtained using PAN analytical diffractometer with Cu-K_{α} radiation in Bragg-Brentano geometry. The X-ray diffraction study was performed using the K_{α} line with copper (Cu) as an anticathode according to the Bragg-Brentano method. The initial samples showed bright emission and the X-ray diffraction (XRD) study determined the presence of three different phases. The determined phases were not known in the art and a Rietveld analysis was not performed as the structural similarity of the synthesized compounds with other compounds present in the database were not found.

The three new phases detected by XRD remained unidentified after extensive efforts to index the spectra. Purified powder materials for each phase were then melted and solidified to form respective single crystals to resolve the structures. After obtaining a phase of pure powder, the powder was melted in an excess of SrBr₂, which was used as flux. The melted powder was then cooled slowly in the furnace at 5°C/hr. rate. The excess flux material was washed with alcohol and the crystals were collected. With slow cooling, single crystals were obtained which were large enough to perform single crystal XRD and the respective phases were determined to be Sr₃siO₄Br₂, Sr₉Si₃O₁₂Br₆ and Sr₅Si₂O₇Br₄.

One compound identified in the experiment described above was a monoclinic crystal phase having formula Sr₃SiO₄Br₂:Eu²⁺, where the crystal had three unequal crystal axes with one oblique intersection in the crystal structure. An emission spectrum near 600 nm was obtained for the phosphor phase of formula Sr₃SiO₄Br₂:Eu²⁺, as shown in FIG. 1. The Sr₃SiO₄Br₂:Eu²⁺ compound showed characteristic red emission. FIG. 1 illustrates that this phosphor phase showed a broad spectrum with a peak at 590 nm upon 450 nm excitation.

Another phase identified in the experiment described above included a triclinic crystal structure having formula Sr₉Si₃O₁₂Br₆:Eu²⁺, where the crystal had three unequal crystal axes intersecting at oblique angles. An emission spectrum near 550 nm was obtained for the phosphor phase having formula Sr₉Si₃O₁₂Br₆:Eu²⁺, as shown in FIG. 2. FIG. 2 illustrates that this phosphor phase emits a broad spectrum with a peak at 545 nm upon 350 nm excitation.

The excitation-emission spectra of another phosphor phase of formula Sr₅Si₂O₇Br₄:Eu²⁺ are illustrated in FIG. 3, where the phosphor (Sr₅Si₂O₇Br₄:Eu²⁺) emits near 550 nm (as shown in FIG. 3). The narrower emission band observed for this phosphor phase suggests that the phosphor may provide higher efficacy and desired color relative to standard LED phosphors that are available commercially.

The following series of examples present the characterization of reference phosphor blends in accordance with some embodiments of the present invention. A comparative analysis of the simulation characterization and the characterization studies of the phosphor blends is also presented.

### Example 3: Simulation characterization of phosphor blends

Table 2 shows simulation characterization results for ten phosphor blends at 2700K. The predicted spectral weights of each phosphor are shown in the Table 2. Further, the spectral characteristics i.e., luminosity-lumen per watt (LPW), color rendering index (CRI), and R₉, calculated from the predicted spectra for these blends are also presented in Table 2.

**Table 2: Simulation characterization results for phosphor blends**

| **PFS** | **BSY** | **Sr₃SiO₄Br₂** | **LPW (%)** | **CRI** | **R₉** |
|---|---|---|---|---|---|
| 0 | 0.051 | 0.876 | 100 | 61.3 | -45.5 |
| 0.05 | 0.124 | 0.752 | 100 | 66.9 | -22.1 |
| 0.1 | 0.198 | 0.629 | 100 | 72.5 | -0.6 |
| 0.15 | 0.272 | 0.506 | 100 | 77.9 | 22.5 |
| 0.169 | 0.301 | 0.458 | 100 | 80 | 30.7 |
| 0.2 | 0.346 | 0.383 | 100 | 83.3 | 44 |
| 0.25 | 0.420 | 0.259 | 100 | 88.4 | 64.2 |
| 0.3 | 0.494 | 0.136 | 100 | 92.6 | 84.1 |
| 0.35 | 0.568 | 0.013 | 100 | 91.8 | 95.4 |
| 0.355 | 0.576 | 0 | 100 | 91.5 | 93.7 |

### Example 4: Experimental characterization of phosphor blends

Experimental phosphor blends (samples 1-7; Table 3) were prepared by combining Sr₃SiO₄Br₂:Eu²⁺ (prepared as described in example 1), K₂SiF6:Mn⁴⁺ (PFS) and Ca_{7.9}Eu_{0.1}Mg(SiO₄)₄Cl₂ (CASI-Eu). The amounts (spectral weights) of constituent phosphor compositions in the blends are listed in Table 3. Each phosphor blend was individually mixed with a silicone precursor (Sylgard 184) to attain 25% loading. The mixture was degassed in a vacuum chamber for about 15 minutes. A suitable amount of the mixture was poured into a disc-shaped template (28.7mm diameter and 0.79 mm thick) to form a film (layer?) on the template, held for one hour, and baked for 30 minutes at 90°C. The samples were cut into 5x5 mm² squares for testing.

In addition, two comparative blends (samples 8-9) were prepared by combining K₂SiF6:Mn⁴⁺ and Ca_{7.9}Eu_{0.1}Mg(SiO₄)₄Cl₂ (CASI-Eu) in amounts as listed in Table 3. These comparative blends did not include Sr₃SiO₄Br₂:Eu²⁺. The process for preparing the comparative blends was similar to the process used for preparing the blend samples 1-7.

All the samples (samples 1-9) were tested for their spectral characteristics. The spectral characteristics: color rendering index (CRI) and Rₐ, correlated color temperature (CCT), luminosity-lumen per watt (LPW), and ccx and ccy for the samples 1-9 are given in Table 3. These samples generate white light having good red-green contrast while maintaining high luminosity and CRI value at a low CCT i.e., between 2500K and 3000K. It is clear from Table 2 and Table 3 that the predicted spectral characteristics are approximately same to the experimental spectral characteristics.

It can be clearly observed from Table 3 that the addition of Sr₃SiO₄Br₂:Eu²⁺ in the experimental blends (samples 1-7) reduces the amount of PFS required in the blends when compared to the comparative blends (samples 8-9), while maintaining good green-red contrast and high luminosity similar to that of the comparative blends, and improving CRI values as compared to the comparative blends, at a low CCT. Further, samples 4-7 having an amount of PFS reduced by more than about 50% of the amount of PSF in samples 1-3 show characteristics comparable to that of samples 1-3.

**Table 3: Experimental characterization results for phosphor blends**

| **Sample blends** | **PFS** | **CASI-Eu** | **Sr₃SiO₄Br₂:Eu²⁺** | **CCT** | **ccx** | **ccy** | **LP W** | **Rₐ** | **CRI** |
|---|---|---|---|---|---|---|---|---|---|
| Sample 1 | 0.700 | 0.100 | 0.200 | 2775 | 0.4347 | 0.3738 | 277 | 62 | 111 |
| Sample 2 | 0.667 | 0.111 | 0.222 | 2890 | 0.4308 | 0.3791 | 282 | 66 | 115 |
| Sample 3 | 0.667 | 0.111 | 0.222 | 2918 | 0.4343 | 0.3891 | 286 | 66 | 115 |
| Sample 4 | 0.200 | 0.100 | 0.700 | 2949 | 0.4346 | 0.3934 | 304 | 86 | 91 |
| Sample 5 | 0.200 | 0.100 | 0.700 | 3027 | 0.4251 | 0.3829 | 299 | 87 | 93 |
| Sample 6 | 0.182 | 0.091 | 0.727 | 2961 | 0.4263 | 0.3780 | 297 | 85 | 90 |
| Sample 7 | 0.167 | 0.083 | 0.750 | 2830 | 0.4382 | 0.3865 | 301 | 82 | 85 |
| Sample 8 | 0.857 | 0.143 | 0 | 3183 | 0.411 | 0.369 | 265 | 21 | 53 |
| Sample 9 | 0.875 | 0.125 | 0 | 2826 | 0.427 | 0.364 | 260 | 18 | 49 |

While only certain features of the invention have been illustrated and described herein, many modifications and changes will occur to those skilled in the art. It is, therefore, to be understood that the appended claims are intended to cover all such modifications.

## Claims

1. A phosphor composition comprising a first phosphor comprising a phase of general formula (I)
L₃ZO₄(Br₂₋ₙXₙ):Eu²⁺ (I)
wherein 0 ≤ n ≤ 1; L is Zn, Mg, Ca, Sr, Ba, or combinations thereof; Z is Si, Ge, or a combination thereof; and X is F, Cl, I, or combinations thereof,
wherein the first phosphor further comprises an additional phase of general formula (II), general formula (III), or a combination thereof,
L9Z3O12(Br6-nXn):Eu2+ (II)
L5Z2O7(Br4-nXn):Eu2+ (III)
wherein 0 ≤ n ≤ 1; L is Zn, Mg, Ca, Sr, Ba, or combinations thereof; Z is Si, Ge, or a combination thereof; and X is F, Cl, I, or combinations thereof.

2. The phosphor composition of claim 1, wherein L is Sr, and Z is Si.

3. The phosphor composition of claim 1, wherein the phase of general formula (I) is Sr₃SiO₄Br₂: Eu²⁺.

4. The phosphor composition of claim 1, wherein the additional phase of general formula (II) is Sr₉Si₃O₁₂Br₆:Eu²⁺.

5. The phosphor composition of claim 1, wherein the additional phase of general formula (III) is Sr₅Si₂O₇Br₄: Eu²⁺.

6. The phosphor composition of claim 1, further comprising a second phosphor of general formula (IV)
A₂[MF₆]:Mn⁴⁺ (IV)
wherein A is Li, Na, K, Rb, Cs, or combinations thereof;
M is Si, Ge, Sn, Ti, Zr, Al, Ga, In, Sc, Hf, Y, La, Nb, Ta, Bi, Gd, or combinations thereof.

7. The phosphor composition of claim 8, wherein a ratio of a spectral weight of the phase of general formula (I) to a spectral weight of the second phosphor is in a range from 1:5 to 5:1.

8. The phosphor composition of claim 6, wherein M is Si, Ge, Ti, or combinations thereof.

9. The phosphor composition of claim 6, wherein the second phosphor of general formula (IV) is K₂SiF₆:Mn⁴⁺.

10. The phosphor composition of claim 1, further comprising a third phosphor selected from the group consisting of an oxyhalide, garnet, orthosilicate, beta-sialon and combinations thereof.

11. The phosphor composition of claim 10, wherein the third phosphor is Ca₁₋ₓEuₓMg(SiO₄)₄Cl₂, where 0<x≤0.5.

12. A lighting apparatus comprising a light source and the phosphor composition according to claim 1 radiationally coupled to the light source.

13. The lighting apparatus of claim 12, wherein the light source comprises a light emitting diode (LED) device.

14. A back light apparatus comprising a light source and the phosphor composition according to claim 1 radiationally coupled to the light source.

## Patentansprüche

1. Leuchtstoffzusammensetzung, umfassend einen ersten Leuchtstoff, umfassend eine Phase der allgemeinen Formel (I)
L3ZO4(Br2-nXn):Eu2+ (I)
wobei 0 ≤ n ≤ 1; L für Zn, Mg, Ca, Sr, Ba oder Kombinationen davon steht; Z für Si, Ge oder eine Kombination davon steht; und X für F, Cl, I oder Kombinationen davon steht,
wobei der erste Leuchtstoff ferner eine zusätzliche Phase der allgemeinen Formel (II), der allgemeinen Formel (III) oder eine Kombination davon umfasst,
L9Z3O12(Br6-nXn):Eu2+ (II)
L5Z2O7(Br4-nXn):Eu2+ (III)
wobei 0 ≤ n ≤ 1; L für Zn, Mg, Ca, Sr, Ba oder Kombinationen davon steht; Z für Si, Ge oder eine Kombination davon steht; und X für F, Cl, I oder Kombinationen davon steht.

2. Leuchtstoffzusammensetzung nach Anspruch 1, wobei L für Sr steht und Z für Si steht.

3. Leuchtstoffzusammensetzung nach Anspruch 1, wobei die Phase der allgemeinen Formel (I) Sr₃SiO₄Br₂: Eu²⁺ ist.

4. Leuchtstoffzusammensetzung nach Anspruch 1, wobei die zusätzliche Phase der allgemeinen Formel (II) Sr₉Si₃O₁₂Br₆: Eu²⁺ ist.

5. Leuchtstoffzusammensetzung nach Anspruch 1, wobei die zusätzliche Phase der allgemeinen Formel (III) Sr₅Si₂O₇Br₄: Eu²⁺ ist.

6. Leuchtstoffzusammensetzung nach Anspruch 1, ferner umfassend einen zweiten Leuchtstoff der allgemeinen Formel (IV)
A2[MF6]:Mn4+ (IV)
wobei A für Li, Na, K, Rb, Cs oder Kombinationen davon steht; M für Si, Ge, Sn, Ti, Zr, Al, Ga, In, Sc, Hf, Y, La, Nb, Ta, Bi, Gd oder Kombinationen davon steht.

7. Leuchtstoffzusammensetzung nach Anspruch 8, wobei ein Verhältnis eines Spektralgewichts der Phase der allgemeinen Formel (I) zu einem Spektralgewicht des zweiten Leuchtstoffs in einem Bereich von 1:5 bis 5:1 liegt.

8. Leuchtstoffzusammensetzung nach Anspruch 6, wobei M für Si, Ge, Ti oder Kombinationen davon steht.

9. Leuchtstoffzusammensetzung nach Anspruch 6, wobei der zweite Leuchtstoff der allgemeinen Formel (IV) K₂SiF6:Mn⁴⁺ ist.

10. Leuchtstoffzusammensetzung nach Anspruch 1, ferner umfassend einen dritten Leuchtstoff, der ausgewählt ist aus der Gruppe, bestehend aus einem Oxidhalogenid, Granaten, Orthosilikat, beta-Sialon und Kombinationen davon.

11. Leuchtstoffzusammensetzung nach Anspruch 10, wobei der dritte Leuchtstoff Ca₁₋ₓEuₓMg(SiO₄)₄Cl₂ ist, wobei 0 < x ≤ 0,5.

12. Beleuchtungsvorrichtung, umfassend eine Lichtquelle und die Leuchtstoffzusammensetzung nach Anspruch 1, die mit der Lichtquelle strahlungsgekoppelt ist.

13. Beleuchtungsvorrichtung nach Anspruch 12, wobei die Lichtquelle eine Leuchtdioden(LED)-Vorrichtung umfasst.

14. Hintergrundbeleuchtungsvorrichtung, umfassend eine Lichtquelle und die Leuchtstoffzusammensetzung nach Anspruch 1, die mit der Lichtquelle strahlungsgekoppelt ist.

## Revendications

1. Composition de luminophore comprenant un premier luminophore comprenant une phase de formule générale (I)
L₃ZO₄(Br₂₋ₙXₙ):Eu²⁺ (I)
dans laquelle 0 ≤ n ≤ 1 ; L est Zn, Mg, Ca, Sr, Ba ou des combinaisons de ceux-ci ; Z est Si, Ge ou une combinaison de ceux-ci ; et X est F, Cl, I ou des combinaisons de ceux-ci, dans laquelle le premier luminophore comprend en outre une phase supplémentaire de formule générale (II), de formule générale (III) ou une combinaison de celles-ci,
L9Z3O12(Br6-nXn):Eu2+ (II)
L5Z2O7(Br4-nXn) :Eu2+ (III)
dans laquelle 0 ≤ n ≤ 1 ; L est Zn, Mg, Ca, Sr, Ba ou des combinaisons de ceux-ci ; Z est Si, Ge ou une combinaison de ceux-ci ; et X est F, Cl, I ou des combinaisons de ceux-ci.

2. Composition de luminophore selon la revendication 1, dans laquelle L est Sr et Z est Si.

3. Composition de luminophore selon la revendication 1, dans laquelle la phase de formule générale (I) est Sr₃SiO₄Br₂:Eu²⁺.

4. Composition de luminophore selon la revendication 1, dans laquelle la phase supplémentaire de formule générale (II) est Sr₉Si₃O₁₂Br₆:Eu²⁺.

5. Composition de luminophore selon la revendication 1, dans laquelle la phase supplémentaire de formule générale (III) est Sr₅Si₂O₇Br₄:Eu²⁺.

6. Composition de luminophore selon la revendication 1, comprenant en outre un deuxième luminophore de formule générale (IV)
A₂[MF₆]:Mn⁴⁺ (IV)
dans laquelle A est Li, Na, K, Rb, Cs ou des combinaisons de ceux-ci ;
M est Si, Ge, Sn, Ti, Zr, Al, Ga, In, Sc, Hf, Y, La, Nb, Ta, Bi, Gd ou des combinaisons de ceux-ci.

7. Composition de luminophore selon la revendication 8, dans laquelle un rapport d'une pondération spectrale de la phase de formule générale (I) sur une pondération spectrale du deuxième luminophore est dans une plage de 1:5 à 5:1.

8. Composition de luminophore selon la revendication 6, dans laquelle M est Si, Ge, Ti ou des combinaisons de ceux-ci.

9. Composition de luminophore selon la revendication 6, dans laquelle le deuxième luminophore de formule générale (IV) est K₂SiF₆:Mn⁴⁺.

10. Composition de luminophore selon la revendication 1, comprenant en outre un troisième luminophore sélectionné parmi le groupe constitué d'un oxyhalogénure, d'un grenat, d'un orthosilicate, d'un bêta-sialon et des combinaisons de ceux-ci.

11. Composition de luminophore selon la revendication 10, dans laquelle le troisième luminophore est Ca₁₋ₓEuₓMg(SiO₄)₄Cl₂, où 0 < x ≤ 0,5.

12. Appareil d'éclairage comprenant une source de lumière et la composition de luminophore selon la revendication 1 couplée par rayonnement à la source de lumière.

13. Appareil d'éclairage selon la revendication 12, dans lequel la source de lumière comprend un dispositif à diode électroluminescente (DEL).

14. Appareil de rétro-éclairage comprenant une source de lumière et la composition de luminophore selon la revendication 1 couplée par rayonnement à la source de lumière.
